(19) Europäisches Patentamt
European Patent Office
Office européen des brevets

(11) **EP 1 908 587 A1**

(12) **EUROPEAN PATENT APPLICATION**
published in accordance with Art. 153(4) EPC

(43) Date of publication:
**09.04.2008 Bulletin 2008/15**

(21) Application number: **06781138.0**

(22) Date of filing: **10.07.2006**

(51) Int Cl.:
*B32B 27/36* (2006.01)      *B32B 27/20* (2006.01)
*C08K 3/00* (2006.01)       *C08L 67/02* (2006.01)
*G02B 5/02* (2006.01)       *G02B 5/08* (2006.01)
*G02F 1/13357* (2006.01)    *G09F 13/14* (2006.01)

(86) International application number:
**PCT/JP2006/314113**

(87) International publication number:
**WO 2007/007882 (18.01.2007 Gazette 2007/03)**

(84) Designated Contracting States:
**DE FR GB**

(30) Priority: **11.07.2005 JP 2005201324**

(71) Applicant: **Teijin Dupont Films Japan Limited
Tokyo 100-0011 (JP)**

(72) Inventors:
• **KUSUME, Hiroshi
Anpachi-cho,
Anpachi-gun, Gifu 5030123 (JP)**

• **OYAMATSU, Atsushi
Anpachi-cho,
Anpachi-gun, Gifu 5030123 (JP)**

(74) Representative: **Hallybone, Huw George et al
Carpmaels and Ransford
43-45 Bloomsbury Square
London WC1A 2RA (GB)**

(54) **LAMINATE FILM**

(57)      A white laminated film which has practically sufficient reflectivity at a visible range, can be formed stably, is free from deterioration (yellowing) by ultraviolet radiation, rarely deforms by heat and can be advantageously used as a reflector substrate for liquid crystal displays and internal illumination type electrically spectacular signs, is provided.

The laminated film comprises a first layer of a composition which comprises 31 to 60 wt% of inert particles having an average particle diameter of 0.3 to 3.0 μm and 40 to 69 wt% of a polyester consisting of 1 to 100 mol% of naphthalenedicarboxylic acid and 0 to 99 mol% of terephthalic acid as a dicarboxylic acid component and ethylene glycol as a diol component, and a layer B of a composition which comprises 0 to 30 wt% of inert particles having an average particle diameter of 0.3 to 3.0 μm and 70 to 100 wt% of a polyester consisting of 3 to 20 mol% of naphthalenedicarboxylic acid and 80 to 97 mol% of terephthalic acid as a dicarboxylic acid component and ethylene glycol as a diol component and which is in direct contact with the first layer.

EP 1 908 587 A1

**Description**

Technical Field

The present invention relates to a laminated film and its application making use of its reflecting properties and light resistance. More specifically, it relates to a laminated film having a high reflectance and excellent light resistance and heat resistance and its application in reflectors, etc.

Background Art

A backlighting system in which a liquid crystal display is illuminated from the back has been employed. However, a side lighting system is now widely used because a liquid crystal display can be made thin and uniformly illuminated (refer to JP-A 63-62104, JP-B 8-16175, JP-A 2001-226501 and JP-A 2002-90515). In this side lighting system, a reflector which is installed on the rear side needs to have high reflecting properties and diffusion properties.

Since ultraviolet radiation is generated from the cold cathode tube of a light source used as an illuminator for applying light from the side or the back directly, if the use time of a liquid crystal display is prolonged, the film of a reflector deteriorates by ultraviolet radiation and the brightness of a screen lowers. As a liquid crystal display having a large screen and high brightness is now strongly desired and the amount of heat generated from the light source increases, it is necessary to suppress the deformation of the film by heat.

Disclosure of the Invention

It is an object of the present invention to provide a white laminated film which solves the above problems of the prior art, has practically sufficient reflectivity at a visible range, can be formed stably, is free from deterioration (yellowing) by ultraviolet radiation, rarely deforms by heat and can be advantageously used as a reflector substrate for liquid crystal displays and internal illumination type electrically spectacular signs.

It is another object of the present invention to provide a reflector which is the above laminated film.

It is still another object of the present invention to provide a backlight unit for liquid crystal displays, which comprises the above laminated film as a reflector and a liquid crystal display.

It is a further object of the present invention to provide a back sheet for solar cells, which is the above laminated film.

Other objects and advantages of the present invention will become apparent from the following description.

According to the present invention, firstly, the above objects and advantages of the present invention are attained by a laminated film comprising (A) a first layer of a first composition which comprises (a1) 31 to 60 wt% of inert particles having an average particle diameter of 0.3 to 3.0 $\mu$m and (a2) 40 to 69 wt% of a first polyester consisting of 1 to 100 mol% of naphthalenedicarboxylic acid and 0 to 99 mol% of terephthalic acid as a dicarboxylic acid component and ethylene glycol as a diol component, and (B) a second layer of a second composition which comprises (b1) 0 to 30 wt% of inert particles having an average particle diameter of 0.3 to 3.0 $\mu$m and (b2) 70 to 100 wt% of a second polyester consisting of 3 to 20 mol% of naphthalenedicarboxylic acid and 80 to 97 mol% of terephthalic acid as a dicarboxylic acid component and ethylene glycol as a diol component, one side or both sides of the second layer being in direct contact with the first layer.

According to the present invention, secondly, the above objects and advantages of the present invention are attained by a backlight unit for liquid crystal displays, comprising the above laminated film of the present invention as a reflector or a liquid crystal display.

According to the present invention, thirdly, the above objects and advantages of the present invention are attained by use of the laminated film of the present invention as a back sheet for solar cells.

Best Mode for Embodiments of the Invention

The present invention will be described in detail hereinunder.

Polyester

The laminated film of the present invention comprises a first layer and a second layer, and the first layer is in direct contact with one side or both sides of the second layer. The first layer is made of a first composition which comprises 31 to 60 wt% of inert particles having an average particle diameter of 0.3 to 3.0 $\mu$m and 40 to 69 wt% of a first polyester comprising 1 to 100 mol% of naphthalenedicarboxylic acid and 0 to 99 mol% of terephthalic acid as a dicarboxylic acid component and ethylene glycol as a diol component.

In the first polyester, the content of naphthalenedicarboxylic acid in the dicarboxylic acid component is 1 to 100 mol%, preferably 3 to 99 mol%. When the content is lower than 1 mol%, heat resistance may not improve or stretchability cannot be ensured.

In the first polyester, the content of terephthalic acid in the dicarboxylic acid component is 0 to 99 mol%. When the content is higher than 99 mol%, heat resistance cannot be ensured.

The second layer is made of a second composition which comprises 0 to 30 wt% of inert particles having an average particle diameter of 0.3 to 3.0 $\mu$m and 70 to 100 wt% of a polyester comprising 3 to 20 mol% of naphthalenedicarboxylic acid and 80 to 97 mol% of terephthalic acid as a dicarboxylic acid component and ethylene glycol as a diol component.

In this second polyester, the content of naphthalenedicarboxylic acid in the dicarboxylic acid component is 3 to 20 mol%, preferably 4 to 18 mol%. When the content is lower than 3 mol%, film formability cannot be ensured and when the content is higher than 20 mol%, heat resistance and film formability may deteriorate.

In this second polyester, the content of terephthalic acid in the dicarboxylic acid component is 80 to 97 mol%. When the content is lower than 80 mol%, film formability may deteriorate. When the content is higher than 97 mol%, heat resistance may lower.

The first polyester of the first layer preferably contains substantially no elemental antimony. The expression "substantially no" means that the content of the elemental antimony is 20 ppm or less, preferably 15 ppm or less, more preferably 10 ppm or less. When the first polyester contains elemental antimony substantially, in the case of a white film, it look like a black streak, thereby greatly impairing the appearance of the film disadvantageously.

To obtain a polyester containing substantially no elemental antimony, the polyester is polymerized by using a catalyst other than antimony compounds. The catalyst used for the polymerization of the polyester is preferably one selected from manganese (Mn) compounds, titanium (Ti) compound and germanium (Ge) compounds.

The titanium compounds include titanium tetrabutoxide and titanium acetate.

The germanium compounds include amorphous germanium oxide, fine crystalline germanium oxide, a solution of germanium oxide dissolved in glycol in the presence of an alkali metal, alkali earth metal or a compound thereof, or a solution of germanium oxide dissolved in water.

Inert particles

The first composition of the first layer contains 31 to 60 wt% of inert particles having an average particle diameter of 0.3 to 3.0 $\mu$m. When the amount of the inert particles is smaller than 31 wt%, reflectance may lower or deterioration by ultraviolet radiation may become marked and when the amount is larger than 60 wt%, the film is easily broken. The second composition of the second layer contains 0 to 30 wt% of inert particles having an average particle diameter of 0.3 to 3.0 $\mu$m. The second composition may not contain the inert particles but preferably contains 1 to 30 wt% of the inert particles. When the amount of the inert particles is smaller than 1 wt%, slipperiness cannot be ensured and when the amount is larger than 30 wt%, the film is easily broken.

The average particle diameter of the inert particles contained in the first layer and the second layer is 0.3 to 3.0 $\mu$m, preferably 0.4 to 2.5 $\mu$m, more preferably 0.5 to 2.0 $\mu$m. When the average particle diameter is smaller than 0.3 $\mu$m, dispersibility becomes too low and the agglomeration of the particles occurs, whereby a trouble readily occurs in the production process, coarse projections may be formed on the film, the film may be inferior in gloss, or the filter used for melt extrusion may be clogged with coarse particles. When the average particle diameter is larger than 3.0 $\mu$m, the surface of the film becomes rough, thereby reducing gloss and making it difficult to control the glossiness of the film to a suitable range.

The half-value width of the grain size distribution of the inert particles is preferably 0.3 to 3.0 $\mu$m, more preferably 0.3 to 2.5 $\mu$m.

To obtain high reflectivity, a white pigment is preferably used as the inert particles. Preferred examples of the white pigment include titanium oxide, barium sulfate, calcium carbonate and silicon dioxide. Out of these, barium sulfate is particularly preferably used. The barium sulfate may be lamellar or spherical. A higher reflectance can be obtained by using barium sulfate.

When titanium oxide is used as the inert particles, rutile type titanium oxide is preferably used. When rutile type titanium oxide is used, yellowing occurs less after a polyester film is exposed to radiation for a long time than when anatase type titanium oxide is used, thereby making it possible to suppress the change of a color difference. When this rutile type titanium oxide is treated with a fatty acid such as stearic acid or a derivative thereof before use, its dispersibility can be improved and the gloss of the film can be further improved.

When rutile type titanium oxide is used, it is preferred that it should be made uniform in size and coarse particles should be removed by a purification process before it is added to the polyester. The industrial means of the purification process is grinding means such as a jet mill or ball mill, or classification means such as dry or wet centrifugal separation. These means may be used alone or in combination of two or more stepwise.

To contain the inert particles in the polyester, any one of the following methods is preferably employed.

(i) The inert particles are added before the end of an ester interchange reaction or esterification reaction or before the start of a polycondensation reaction in the synthesis of the polyester.
(ii) The inert particles are added to the polyester and melt kneaded with the polyester.
(iii) A master pellet containing a large amount of the inert particles is manufactured in the method (i) or (ii) and kneaded with a polyester containing no additives to contain predetermined amounts of additives.
(iv) The master pellet (iii) is directly used.

When the above method (i) in which the inert particles are added in the synthesis of the polyester is employed, titanium oxide is preferably added to a reaction system as slurry containing it dispersed in glycol. When titanium oxide is used, the method (iii) or (iv) is preferably employed.
In the present invention, the molten polymer is preferably filtered by using a nonwoven cloth filter having an average opening of 10 to 100 $\mu$m, preferably 20 to 50 $\mu$m which is composed of a stainless steel thin wire having a diameter of 15 $\mu$m or less as a filter for forming a film. By carrying out this filtration, a film containing little coarse foreign matter can be obtained by suppressing the agglomeration of particles which readily agglomerate into coarse particles.
The amount of the inert particles is preferably 10 to 80 wt%, more preferably 15 to 70 wt%, much more preferably 20 to 60 wt%, particularly preferably 25 to 55 wt% based on 100 wt% of the total of the first layer and the second layer. When the amount of the inert particles is smaller than 10 wt% based on the film, required reflectance and whiteness are not obtained, and when the amount of the inert particles is larger than 80 wt%, breakage readily occurs during film formation.

Additives

The laminated film of the present invention may contain a fluorescent brightener. When it contains a white brightener, the white brightener is contained in an amount of 0.005 to 0.2 wt%, preferably 0.01 to 0.1 wt% based on the first composition of the first layer or the second composition of the second layer. When the amount of the fluorescent brightener is smaller than 0.005 wt%, reflectance at a wavelength of around 350 nm becomes unsatisfactory, whereby there isn't much point in adding the fluorescent brightener and when the amount is larger than 0.2 wt%, the inherent color of the fluorescent brightener appears disadvantageously.
OB-1 (of Eastman Co., Ltd.), Uvitex-MD (of Ciba Geigy Co., Ltd.) or JP-Conc (of Nippon Kagaku Kogyosho Co., Ltd.) may be used as the fluorescent brightener.
To further improve performance as required, a coating composition containing an antioxidant, an ultraviolet light absorber and a fluorescent brightener may be applied to at least one side of the film.
The thickness of the first layer is preferably 40 to 90, more preferably 50 to 85 when the total thickness of the first layer and the second layer is 100. When the thickness of the first layer is less than 40, reflectance may deteriorate and when the thickness is larger than 90, it is not preferred from the viewpoint of stretchability.
The laminated film of the present invention may consist of two layers which are the first layer and the second layer or three layers which are the first layer formed on both sides of the second layer and the second layer.
Another layer may be further formed on one side or both sides of the laminated film of the present invention to provide another function. The another layer is, for example, a transparent polyester resin layer, metal thin film, hard coat layer or ink receiving layer.
As one example of the method of manufacturing the laminated film of the present invention, a method of manufacturing a laminated film consisting of the first layer, the second layer and the first layer will be described hereinbelow. A laminated unstretched sheet is manufactured from a molten polymer extruded from a die by a simultaneous multi-layer extrusion method using a feed block. That is, the molten first composition for forming the first layer and the molten second composition for forming the second layer are laminated together by using the feed bock in such a manner that the first layers are existent on both sides of the second layer and extruded from the die. At this point, the molten layers laminated together by the feed block maintain a laminated form.
The unstretched sheet extruded from the die is solidified by cooling on a casting drum to become an unstretched film. This unstretched film is heated by heating rollers or infrared radiation to be stretched in the longitudinal direction so as to obtain a stretched film. This stretching is preferably carried out by using a speed difference between two or more rolls. The stretching temperature is preferably equal to or higher than the glass transition point (Tg) of the polyester, more preferably a temperature from Tg to (Tg+70˚C). The draw ratio which depends on the requirements from application purpose is preferably 2.2 to 4.0 times, more preferably 2.3 to 3.9 times in the longitudinal direction and a direction (may also called "transverse direction" hereinafter) orthogonal to the longitudinal direction. When the draw ratio is lower than 2.2 times, the thickness uniformity of the film degrades and a satisfactory film is not obtained. When the draw ratio is higher than 4.0 times, the film is easily broken during film formation.

The film stretched in the longitudinal direction is subsequently stretched in the transverse direction, thermally set and thermally relaxed to obtain a biaxially stretched film. These treatments are carried out while the film is traveled. Stretching in the transverse direction starts from a temperature higher than the glass transition point (Tg) of the polyester. It is carried out by raising the temperature to a point (5 to 70) ˚C higher than Tg. The temperature for stretching in the transverse direction may be raised continuously or stepwise (sequentially) but generally sequentially. For example, the transverse stretching zone of a tenter is divided into a plurality of sub-zones along the traveling direction of the film and a heating medium having a predetermined temperature is caused to flow into each sub-zone so as to increase the temperature. The draw ratio in the transverse direction which depends on the requirements from application purpose is preferably 2.5 to 4.5 times, more preferably 2.8 to 3.9 times. When the draw ratio is lower than 2.5 times, the thickness uniformity of the film degrades and a satisfactory film is not obtained and when the draw ratio is higher than 4.5 times, the film is easily broken during film formation.

It is recommended to heat the film stretched in the transverse direction at a temperature from (Tm-20)˚C to (Tm-100)˚C while both ends of the film are held to fix its width or under a width loss of 10 % or less to reduce its heat shrinkage factor. When the temperature is higher than that, the flatness of the film degrades and the thickness nonuniformity becomes large disadvantageously. When the heat setting temperature is lower than (Tm - 80) ˚C, the heat shrinkage factor may increase. To adjust the amount of heat shrinkage at a temperature lower than the temperature from (Tm-20)˚C to (Tm-100)˚C while the film temperature is returned to normal temperature after heat setting, the film can be relaxed in the longitudinal direction by cutting off both ends of the held film and controlling the take-up speed of the film in the longitudinal direction. The relaxing means is to control the speeds of the rolls on the exit side of the tenter. As for the relaxation ratio, the speeds of the rolls are reduced by preferably 0.1 to 1.5 %, more preferably 0.2 to 1.2 %, particularly preferably 0.3 to 1. 0 % with respect to the film line speed of the tenter to relax the film (this value is called "relaxation ratio"). The heat shrinkage factor in the longitudinal direction is adjusted by controlling this relaxation ratio. A desired heat shrinkage factor in the transverse direction of the film can be obtained by reducing the width before the both ends of the film are cut off.

The laminated film of the present invention obtained as described above has a heat shrinkage factor at 85˚C in two crossing directions of preferably 0.5 % or less, more preferably 0.4 % or less, most preferably 0.3 % or less.

The thickness of the laminated film after biaxial stretching is preferably 25 to 250 $\mu$m, more preferably 40 to 250 $\mu$m, particularly preferably 50 to 250 $\mu$m. When the thickness is smaller than 25 $\mu$m, reflectance drops and when the thickness is larger than 250 $\mu$m, a further increase in reflectance cannot be expected.

The laminated film of the present invention obtained as described above has a reflectance on at least one side of preferably 90 % or more, more preferably 92 % or more, much more preferably 94 % or more as an average reflectance at a wavelength of 400 to 700 nm. When the reflectance is lower than 90 %, satisfactory screen brightness cannot be obtained.

When the laminated film of the present invention is biaxially stretched, voids are formed in the first layer containing a large amount of inert particles. Therefore, even when the laminated film of the present invention is biaxially stretched, it is hard to confirm that the first layer is biaxially stretched but it can be confirmed that the second layer is biaxially stretched.

The apparent density of the laminated film of the present invention which depends on the total amount of voids and the type and amount of the inert particles is 1.00 to 1.35 g/cm$^3$ in most cases.

Examples

The following examples are given to further illustrate the present invention. Characteristic property values were measured by the following methods.

(1) Film thickness

The thickness of a film sample was measured at 10 points with an electric micrometer (K-402B of Anritsu Corporation), and the average value of these measurement data was taken as the thickness of the film.

(2) Thickness of each layer

After the sample was cut into a triangle and fixed in a capsule, it was embedded into an epoxy resin. The embedded sample was sliced in a vertical direction with a microtome (ULTRACUT-S) to obtain a piece having a thickness of 50 nm, and the piece was observed and photographed by a transmission type electron microscope at an acceleration voltage of 100 kV to measure the thickness of each layer from the photomicrograph so as to obtain an average thickness.

(3) Apparent density

The film sample was cut into a 100 mm x 100 mm square and its thickness was measured with an electric micrometer (K-402B of Anritsu Corporation) at 10 points to obtain the average value d (nm) of these measurement data.
The weight w (g) of this film was measured to a unit of $10^{-4}$ g to obtain its apparent density.

$$\texttt{Apparent density = w/d x 100}$$

(4) Reflectance

An integrating sphere was set in a spectrophotometer (UV-3101PC of Shimadzu Corporation) to measure the reflectance of the sample when the reflectance of a $BaSO_4$ white board was 100 % at 400 to 700 nm, and the reflectance was read from the obtained chart at intervals of 2 nm. When one surface layer of the film was layer A and the other surface layer was layer B, the measurement was made from the layer A. The average value obtained within the above range was judged based on the following criteria.
○: average reflectance is 90 % or more in all the measurement areas
Δ: average reflectance is 90 % or more in most measurement areas but less than 90 % in some of them
✕: average reflectance is less than 90 % in all the measurement areas

(5) Stretchability

It was observed whether the film could be formed stably by stretching it to 2.5 to 3.4 times in the longitudinal direction and to 3 . 5 to 3 . 7 times in the transverse direction. The stretchability of the film was evaluated based on the following criteria.
○: the film can be formed stably for 1 hours or longer
✕: the film is broken in less than 1 hour and stable film formation is impossible

(6) Heat shrinkage

The film was kept in an oven set to 85°C under no tension for 30 minutes and the distance between gauge marks before and after heating was measured to calculate the heat shrinkage factor (heat shrinkage factor at 85°C) of the film based on the following equation.

$$\texttt{Heat shrinkage factor \% = ((L}_0\texttt{ - L)/L}_0\texttt{) x 100}$$

$L_0$: distance between gauge marks before heating
L: distance between gauge marks after heating

(7) Glass transition point (Tg), melting point (Tm)

The glass transition point and the melting point were measured at a temperature elevation rate of 20 m/min with a differential scanning calorimeter (2100 DSC of TA Instruments Co., Ltd.).

(8) Deterioration by ultraviolet radiation (evaluation of light resistance)

A color change before and after 300 hours of exposure to light with a xenon lamp (Suntest CPS+) at a panel temperature of 60°C was observed. When one surface layer of the film was layer A and the other surface layer was layer B, light was applied to the layer A to measure the color change.
The initial hue ($L_{1*}$, $a_{1*}$, $b_{1*}$) of the film and the hue of the film ($L_{2*}$, $a_{2*}$, $b_{2*}$) after exposure were measured with a color difference meter (SZS-Σ90 Color Measuring System of Nihon Denshoku Co., Ltd.) to evaluate deterioration by ultraviolet radiation based on a color change dE* (equation 1) as follows.

(equation 1)

$$dE* = \{(L_1* - L_2*)^2 + (a_1* - a_2*)^2 + (b_1* - b_2*)^2\}^{1/2}$$

○ : dE* $\leqq$ 10
Δ: 10 < dE* $\leqq$ 15
✕ : 15 < dE*

(9) deformation by heat (evaluation of deflection)

After the film sample was cut into an A4-sized sample and heated in an oven at 80˚C for 30 minutes while four corners of the film were fixed by a metal frame, its deformation (deflection of the film) was visually observed.
○: no deflection is seen
Δ: slight deflection is partially seen
✕ : A deflected portion exists and uneven of the deflection is seen as a bump having a height of 5 mm or more

Example 1

132 parts by weight of dimethyl terephthalate, 23 parts by weight (12 mol% based on the acid component of the polyester) of dimethyl 2,6-naphtahlenedicarboxylate, 96 parts by weight of ethylene glycol, 3.0 parts by weight of diethylene glycol, 0.05 part by weight of manganese acetate and 0.012 part by weight of lithium acetate were fed to a flask equipped with a fractionating column and a distillation condenser and heated at 150 to 235˚C under agitation to carry out an ester interchange reaction while methanol was distilled out. After methanol was distilled out, 0.03 part by weight of trimethyl phosphate and 0.04 part by weight of germanium dioxide were added, and the reaction product was transferred to a polymerization reactor. The inside pressure of the reactor was reduced to 0.5 mmHg gradually under agitation, and the temperature was raised to 290˚C to carry out a polycondensation reaction. The obtained copolyester had a diethylene glycol content of 2.5 wt%, an elemental germanium content of 50 ppm and an elemental lithium content of 5 ppm. This polyester resin was used to form the first layer and the second layer, and inert particles shown in Table 1 were added to the polyester resin. The resulting polyester resins were supplied into two extruders heated at 285˚C and joined together by using a double-layer feed block apparatus so that the first layer polymer and the second layer polymer are contacted each other like as the first layer/the second layer and molded into a sheet from a die while its laminated state was maintained. Further, this sheet was solidified by cooling on a cooling drum having a surface temperature of 25˚C, and the obtained unstretched film was heated at a given temperature to be stretched in the longitudinal direction and cooled between rolls at 25˚C. Subsequently, the film stretched in the longitudinal direction was guided to a tenter while both ends of the film were held by a clip and stretched in a direction (transverse direction) orthogonal to the longitudinal direction in an atmosphere heated at 120˚C. Thereafter, the film was heat set at a temperature shown in Table 2 in the tenter, relaxed in the longitudinal direction and toe-in in the transverse direction under the conditions shown in Table 2, and cooled to room temperature to obtain a biaxially stretched film. The physical properties of the obtained film as a reflector substrate are shown in Table 2.

Examples 2 to 8

Films were manufactured under the conditions shown in Table 2 by changing the amounts, the inert particles and the acid component of the polyester as shown in Table 1 and evaluated.

Example 9

An isophthalic acid copolymer was manufactured by changing 23 parts by weight of dimethyl 2,6-naphthalenedicarboxylate of Example 1 to 18 parts by weight of dimethyl isophthalate (12 mol% based on the acid component of the polyester) in the stage of manufacturing a polymer. This polymer was blended with the 2,6-naphthalenedicarboxylic acid copolymer prepared in Example 1 in a molar ratio based on the acid component of about 1/11, and a film was manufactured from the blend under the conditions shown in Tables 1 and 2 and evaluated.

Examples 10 and 11

The procedure of Example 1 was repeated except that 0. 05 part by weight of manganese acetate was changed to 0.02 part by weight of titanium acetate and dimethyl 2,6-naphthalenedicarboxylate (100 mol%) was used as the dicarboxylic acid component. The obtained polyester had an intrinsic viscosity of 0.68 dl/g, a melting point of 268°C, a diethylene glycol content of 2.5 wt%, an elemental titanium content of 15 ppm and an elemental lithium content of 5 ppm. This polyester resin was used in the first layer, the copolymer prepared in Example 1 was used in the second layer, and the inert particles shown in Table 1 were added to manufacture films as shown in Table 2.

Comparative Examples 1 and 2

An ester interchange reaction was carried out by using 85 parts by weight of dimethyl terephthalate, 60 parts by weight of ethylene glycol and 0.09 part by weight of calcium acetate as a catalyst in accordance with a commonly used method, an ethylene glycol solution containing 10 wt% of trimethyl phosphate was added to ensure that the amount of a phosphorus compound became 0.18 wt% based on the polymer, and then 0.03 part by weight of antimony trioxide was added as a catalyst. Thereafter, a polycondensation reaction was carried out at a high temperature under a reduced pressure in accordance with a commonly used method to obtain polyethylene terephthalate having a limiting viscosity of 0.60. This polyester had an intrinsic viscosity of 0.65 dl/g, a melting point of 257°C, a diethylene glycol content of 1.2 wt%, an elemental antimony content of 30 ppm and an elemental calcium content of 10 ppm. Inert particles shown in Table 1 were added to this resin, and the resulting mixtures were formed into the first layer and the second layer under conditions shown in Table 2.

Comparative Example 3

Inert particles were added to the polymer (polyethylene naphthalate) obtained in Examples 10 and 11 as shown in Table 1 to form the second layer. Although a film was formed as shown in Table 2, its stretchability was extremely low and the film was broken frequently during film formation. Therefore, a film sample could not be prepared.

Comparative Example 4

Inert particles were added to the polymer (polyethylene naphthalate) obtained in Examples 10 and 11 as shown in Table 1 to form the first layer and the second layer. Although a film was formed as shown in Table 2, its stretchability was extremely low and the film was broken frequently during film formation. Therefore, a film sample could not be prepared.

Comparative Example 5

Inert particles shown in Table 1 were added to the polymer obtained in Comparative Examples 1 and 2 to form the first layer (single layer). Although a film was formed as shown in Table 2, its stretchability was extremely low and the film was broken frequently during film formation. Therefore, a film sample could not be prepared.

Comparative Example 6

Inert particles shown in Table 1 were added to the isophthalic acid copolymer obtained in Example 9 and a film was formed by using a three-layer feed block as shown in Table 2. The obtained film was inferior in deflection.

Comparative Example 7

A copolyester resin was obtained in the same manner as in Example 1 except that 0.04 part by weight of germanium dioxide was changed to 0.04 part by weight of antimony trioxide. The amount of elemental antimony was 40 ppm. A film was formed from this resin as shown in Tables 1 and 2. It was inferior in light resistance.

Comparative Example 8

A film was manufactured by adding 14 wt% of calcium carbonate as inorganic fine particles to the resin of Comparative Example 1 to form the surface layers (front and rear sides) of a three-layered film and mixing 10 wt% of polymethylpentene resin as an incompatible resin and 1 wt% of polyethylene glycol with polyethylene terephthalate as the resin of a core layer. The obtained film had a distinct streak and was inferior in reflectance, deflection and light resistance as shown in Tables 1 and 2.

Table 1

| | resin | comonomer | copolymerization ratio mol% | inert particles | amount/average particle diameter wt% /μm | Tg °C | Tm °C | Sb element ppm |
|---|---|---|---|---|---|---|---|---|
| **First layer film** | | | | | | | | |
| Ex.1 | PET | NDC | 12 | Barium sulfate | 35/1.2 | 81 | 225 | 0 |
| Ex.2 | PET | NDC | 12 | Barium sulfate | 40/1.2 | 81 | 225 | 0 |
| Ex.3 | PET | NDC | 6 | Titanium dioxide | 45/1.0 | 78 | 240 | 0 |
| Ex.4 | PET | NDC | 12 | Barium sulfate | 50/0.7 | 81 | 225 | 0 |
| Ex.5 | PET | NDC | 12 | Barium sulfate | 36/0.7 | 81 | 225 | 0 |
| Ex.6 | PET | NDC | 12 | Barium sulfate | 55/1.2 | 81 | 225 | 0 |
| Ex.7 | PET | NDC | 12 | Barium sulfate | 48/1.2 | 81 | 225 | 0 |
| Ex.8 | PET | NDC | 6 | Calcium carbonate | 45/1.5 | 78 | 240 | 0 |
| Ex.9 | PET | NDC/IPA | 11/1 | Barium sulfate | 45/1.2 | 80 | 225 | 0 |
| Ex.10 | PEN | – | – | Barium sulfate | 31/1.2 | 120 | 268 | 0 |
| Ex.11 | PEN | – | – | Barium sulfate | 31/1.2 | 120 | 268 | 0 |

Ex.: Example
PET: polyethylene terephthalate
IPA: isophthalic acid
NDC: 2,6-naphthalenedicarboxylic acid
PMX: polymethylpentene
PEN: polyethylene 2,6-naphthalate

EP 1 908 587 A1

Table 1 (continued)

| | | | First layer film | | | | | | |
|---|---|---|---|---|---|---|---|---|---|
| | resin | comonomer | copolymerization ratio<br><br>mol% | inert particles | amount/average particle diameter<br>wt% /μm | Tg<br>°C | Tm<br>°C | Sb element<br>ppm |
| C.Ex.1 | PET | - | - | Barium sulfate | 5/1.5 | 79 | 257 | 30 |
| C.Ex.2 | PET | - | - | Titanium dioxide | 10/0.3 | 79 | 257 | 30 |
| C.Ex.3 | PET | - | - | Titanium dioxide | 7/1.5 | 79 | 257 | 30 |
| C.Ex.4 | PEN | - | - | Barium sulfate | 25/1.5 | 120 | 268 | 0 |
| C.Ex.5 | PET | - | - | Barium sulfate | 31/1.2 | 78 | 255 | 30 |
| C.Ex.6 | PET | IPA | 12 | Barium sulfate | 35/1.2 | 74 | 225 | 0 |
| C.Ex.7 | PET | NDC | 12 | Barium sulfate | 25/1.2 | 81 | 225 | 40 |
| C.Ex.8 | PET | - | - | Calcium carbonate | 14/1.5 | 78 | 255 | 30 |

C.Ex.: Comparative Example
PET: polyethylene terephthalate
IPA: isophthalic acid
NDC: 2,6-naphthalenedicarboxylic acid
PMX: polymethylpentene
PEN: polyethylene 2,6-naphthalate

Table 1 (continued)

| | | | second layer film | | | | | layer constitution |
|---|---|---|---|---|---|---|---|---|
| | Resin | comonomer | copolymerization ratio<br>mol% | inert particles | amount/average particle diameter<br>wt% /μm | Tg<br>°C | Tm<br>°C | first layer/ second layer (partially first layer/ second layer/ first layer) |
| Ex.1 | PET | NDC | 12 | Barium sulfate | 5/1.2 | 83 | 225 | 70/30 |
| Ex.2 | PET | NDC | 12 | Barium sulfate | 30/1.2 | 81 | 225 | 80/20 |
| Ex.3 | PET | NDC | 4 | Titanium dioxide | 10/1.0 | 77 | 242 | 60/40 |
| Ex.4 | PET | NDC | 12 | Barium sulfate | 20/0.7 | 81 | 225 | 76/24 |
| Ex.5 | PET | NDC | 12 | Barium sulfate | 10/0.7 | 81 | 225 | 75/25 |
| Ex.6 | PET | NDC | 12 | Barium sulfate | 10/1.2 | 81 | 225 | 70/30 |
| Ex.7 | PET | NDC | 6 | Barium sulfate | 5/1.2 | 78 | 239 | 80/20 |
| Ex.8 | PET | NDC | 15 | Calcium carbonate | 25/1.5 | 83 | 222 | 50/50 |
| Ex.9 | PET | NDC/IPA | 11/1 | Barium sulfate | 3/1.2 | 80 | 225 | 20/80 |
| Ex.10 | PET | NDC | 12 | Barium sulfate | 4/1.2 | 81 | 225 | 70/30 |
| Ex.11 | PET | NDC | 12 | Barium sulfate | 4/1.2 | 81 | 225 | 20/80 |

Ex.: Example

PET: polyethylene terephthalate   IPA: isophthalic acid   NDC: 2,6-naphthalenedicarboxylic acid   PMX: polymethylpentene   PEN: polyethylene 2,6-naphthalate

EP 1 908 587 A1

Table 1 (continued)

| | Resin | comonomer | copolymerization ratio mol% | inert particles | amount/average particle diameter wt% /μm | Tg °C | Tm °C | first layer/second layer(first layer/second layer/first layer) |
|---|---|---|---|---|---|---|---|---|
| | | | | second layer film | | | | layer constitution |
| C.Ex.1 | PET | - | - | Barium sulfate | 20/1.5 | 79 | 257 | 50/50 |
| C.Ex.2 | PET | - | - | Titanium dioxide | 20/0.3 | 79 | 257 | 70/30 |
| C.Ex.3 | PEN | - | - | Titanium dioxide | 30/1.5 | 120 | 268 | 76/24 |
| C.Ex.4 | PEN | - | - | Barium sulfate | 50/1.5 | 120 | 268 | 60/40 |
| C.Ex.5 | - | - | - | - | - | - | - | Only first layer |
| C.Ex.6 | PET | IPA | 12 | Barium sulfate | 51/1.2 | 74 | 225 | 15/70/15 |
| C.Ex.7 | PET | NDC | 12 | Barium sulfate | 40/1.2 | 81 | 225 | 60/40 |
| C.Ex.8 | PET | - | - | - | addition of PMX resin | 77** | 253** | 6/88/6 |

C.Ex.: Comparative Example

PET: polyethylene terephthalate  IPA: isophthalic acid  NDC: 2,6-naphthalenedicarboxylic acid

PMX: polymethylpentene  PEN: polyethylene 2,6-naphthalate

Table 2

| | draw ratio in longitudinal direction | longitudinal stretching temperature °C | draw ratio in transverse direction | transverse stretching temperature °C | heat setting temperature °C | relaxation ratio/temperature of both-end cut portion |
|---|---|---|---|---|---|---|
| Ex.1 | 2.9 | 95 | 3.7 | 120 | 210 | 0.5/130 |
| Ex.2 | 2.9 | 95 | 3.7 | 120 | 210 | 0.5/130 |
| Ex.3 | 3.4 | 90 | 3.7 | 120 | 210 | 0.4/120 |
| Ex.4 | 2.9 | 90 | 3.5 | 120 | 210 | 0.7/150 |
| Ex.5 | 2.9 | 95 | 3.7 | 120 | 210 | 0.5/150 |
| Ex.6 | 2.9 | 90 | 3.7 | 120 | 210 | 1.0/150 |
| Ex.7 | 2.9 | 90 | 3.7 | 120 | 210 | 0.5/120 |
| Ex.8 | 2.9 | 95 | 3.7 | 120 | 210 | 0.5/130 |
| Ex.9 | 2.5 | 90 | 3.5 | 120 | 210 | 0.5/130 |
| Ex.10 | 2.9 | 140 | 3.6 | 140 | 215 | 0.5/150 |
| Ex.11 | 2.8 | 135 | 3.7 | 140 | 210 | 0.5/150 |
| C.Ex.1 | 2.9 | 90 | 3.7 | 120 | 210 | – |
| C.Ex.2 | 2.9 | 90 | 3.7 | 120 | 210 | 0.5/130 |
| C.Ex.3 | 3.4 | 130 | 3.7 | 135 | 210 | 0.5/130 |
| C.Ex.4 | 3.4 | 140 | 3.7 | 140 | 210 | 0.5/130 |
| C.Ex.5 | 3.4 | 90 | 3.7 | 120 | 210 | 0.5/130 |
| C.Ex.6 | 2.9 | 90 | 3.5 | 120 | 210 | 0.3/130 |
| C.Ex.7 | 2.9 | 90 | 3.7 | 120 | 210 | 0.5/130 |
| C.Ex.8 | 3.4 | 92 | 3.6 | 130 | 230 | – |

Ex.: Example  C.Ex.: Comparative Example

Table 2 (continued)

| | toe-in rate/temperature of toe-in portion | | thickness after biaxial stretching | evaluation of reflectance | observation of deflection | evaluation of light resistance |
|---|---|---|---|---|---|---|
| | % | °C | μm | | | |
| Ex.1 | 2 | 150 | 150 | ○ | ○ | ○ |
| Ex.2 | 2 | 150 | 150 | ○ | ○ | ○ |
| Ex.3 | 1 | 130 | 100 | ○ | ○ | ○ |
| Ex.4 | 3 | 130 | 100 | ○ | ○ | ○ |
| Ex.5 | 3 | 150 | 170 | ○ | ○ | ○ |
| Ex.6 | 3 | 150 | 75 | ○ | ○ | ○ |
| Ex.7 | 3 | 150 | 50 | ○ | ○ | ○ |
| Ex.8 | 2 | 150 | 150 | ○ | ○ | ○ |
| Ex.9 | 2 | 150 | 170 | ○ | ○ | ○ |
| Ex.10 | 2 | 150 | 170 | ○ | ○ | ○ |
| Ex.11 | 2 | 150 | 150 | ○ | ○ | ○ |
| C.Ex.1 | - | - | 150 | × | × | × |
| C.Ex.2 | 2 | 150 | 150 | × | × | △ |
| C.Ex.3 | 3 | 150 | - | - | - | - |
| C.Ex.4 | 3 | 150 | - | - | - | - |
| C.Ex.5 | 3 | 150 | - | - | - | - |
| C.Ex.6 | 3 | 150 | 100 | ○ | × | ○ |
| C.Ex.7 | 1 | 130 | 150 | ○ | ○ | × |
| C.Ex.8 | - | - | 50 | × | × | × |

Ex.: Example   C.Ex.: Comparative Example

EP 1 908 587 A1

14

Table 2 (continued)

| | heat shrinkage factor at 85°C | | stretchability |
|---|---|---|---|
| | Longitudinal direction | transverse direction | |
| Ex.1 | 0.1 | 0.1 | ○ |
| Ex.2 | 0.1 | 0.1 | ○ |
| Ex.3 | 0.2 | 0.2 | ○ |
| Ex.4 | 0.1 | 0.1 | ○ |
| Ex.5 | 0.2 | 0.1 | ○ |
| Ex.6 | 0.1 | 0.1 | ○ |
| Ex.7 | 0.1 | 0.1 | ○ |
| Ex.8 | 0.1 | 0.1 | ○ |
| Ex.9 | 0.1 | 0.1 | ○ |
| Ex.10 | 0.1 | 0.1 | ○ |
| Ex.11 | 0.1 | 0.1 | ○ |
| C.Ex.1 | 0.8 | 0.8 | ○ |
| C.Ex.2 | 0.4 | 0.3 | ○ |
| C.Ex.3 | - | - | × |
| C.Ex.4 | - | - | × |
| C.Ex.5 | - | - | × |
| C.Ex.6 | 0.5 | 0.0 | ○ |
| C.Ex.7 | 0.1 | 0.1 | ○ |
| C.Ex.8 | 0.3 | 0.3 | ○ |

Ex.: Example    C.Ex.: Comparative Example

As described above, according to the present invention, there can be provided a white laminated film which has practically sufficient reflectivity at a visible range, can be formed stably, is free from deterioration (yellowing) by ultraviolet radiation, rarely deforms by heat and can be advantageously used as a reflector substrate for liquid crystal displays and internal illumination type electrically spectacular signs.

Since the laminated film of the present invention has a high ray reflectance, it can be most suitably used in reflectors, especially reflectors for liquid crystal displays and back sheets for solar cells. When it is used as a reflector for these, the first layer is preferably used as a reflection surface.

As for other applications, it can be used as a substitute for paper, that is, a substrate for cards, labels, stickers, delivery slips, image receiving paper for video printers, image receiving paper for ink jet and bar code printers, posters, maps, dust-free paper, display boards, white boards, and receiving sheets used for printing records such as thermosensitive transfer and offset printing, telephone cards and IC cards.

**Claims**

1.   A laminated film comprising (A) a first layer of a first composition which comprises (a1) 31 to 60 wt% of inert particles having an average particle diameter of 0.3 to 3.0 μm and (a2) 40 to 69 wt% of a first polyester comprising 1 to 100 mol% of naphthalenedicarboxylic acid and 0 to 99 mol% of terephthalic acid as a dicarboxylic acid component and ethylene glycol as a diol component, and (B) a second layer of a second composition which comprises (b1) 0 to 30 wt% of inert particles having an average particle diameter of 0.3 to 3.0 $\mu$m and (b2) 70 to 100 wt% of a second polyester comprising 3 to 20 mol% of naphthalenedicarboxylic acid and 80 to 97 mol% of terephthalic acid as a dicarboxylic acid component and ethylene glycol as a diol component, one side or both sides of the second layer being in direct contact with the first layer.

2.  The laminated film according to claim 1, wherein the second composition of the second layer comprises 1 to 30 wt% of inert particles.

3.  The laminated film according to claim 1 or 2, wherein the second layer is biaxially stretched.

4.  The laminated film according to any one of claims 1 to 3, wherein the first polyester of the first composition contains substantially no antimony.

5.  The laminated film according to any one of claims 1 to 3, wherein the thickness of the first layer is 40 to 90 when the total thickness of the first layer and the second layer is 100.

6.  The laminated film according to any one of claims 1 to 3 which has a thickness of 25 to 250 $\mu$m.

7.  The laminated film according to any one of claims 1 to 3 which has two crossing directions in which its heat shrinkage factor at 85°C is 0.5 % at best.

8.  The laminated film according to any one of claims 1 to 3 consisting of the first layer and the second layer.

9.  The laminated film according to any one of claims 1 to 3 consisting of the first layers formed on both sides of the second layer and the second layer.

10.  The laminated film according to any one of claims 1 to 3 which is used as a reflector.

11.  A backlight unit for liquid crystal displays, comprising the laminated film of any one of claims 1 to 3 as a reflector.

12.  A liquid crystal display comprising the laminated film of any one of claims 1 to 3 as a reflector.

13.  The laminated film according to any one of claims 1 to 3 which is used as a back sheet for solar cells.

| INTERNATIONAL SEARCH REPORT | International application No. |
|---|---|
| | PCT/JP2006/314113 |

A. CLASSIFICATION OF SUBJECT MATTER
*B32B27/36*(2006.01)i, *B32B27/20*(2006.01)i, *C08K3/00*(2006.01)i, *C08L67/02*
(2006.01)i, *G02B5/02*(2006.01)i, *G02B5/08*(2006.01)i, *G02F1/13357*(2006.01)i,
*G09F13/14*(2006.01)i
According to International Patent Classification (IPC) or to both national classification and IPC

B. FIELDS SEARCHED

Minimum documentation searched (classification system followed by classification symbols)
B32B1/00-43/00, G02B5/00-5/136, G02F1/1335-13363

Documentation searched other than minimum documentation to the extent that such documents are included in the fields searched
Jitsuyo Shinan Koho          1922-1996   Jitsuyo Shinan Toroku Koho    1996-2006
Kokai Jitsuyo Shinan Koho    1971-2006   Toroku Jitsuyo Shinan Koho    1994-2006

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | WO 2005/026241 A1  (Teijin Dupont Film<br>Kabushiki Kaisha),<br>24 March, 2005 (24.03.05),<br>Claims 1, 2, 4, 5, 7 to 9; page 3, line 23 to<br>page 4, line 21; page 6, line 17 to page 8,<br>line 11; page 17, lines 7 to 10; examples;<br>table 1<br>& EP 1666521 A1 | 1-3,5-13<br>4 |
| Y | JP 2001-247696 A  (Teijin Ltd.),<br>11 September, 2001 (11.09.01),<br>Claim 2; Par. No. [0013]<br>& US 6787202 B2          & EP 1178075 B1<br>& WO 2001/058991 A1 | 4 |

☒  Further documents are listed in the continuation of Box C.          ☐  See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 10 October, 2006 (10.10.06) | 17 October, 2006 (17.10.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.

PCT/JP2006/314113

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2004-269601 A  (Toray Industries, Inc.), 30 September, 2004 (30.09.04), Claim 1; Par. Nos. [0003], [0052], [0068] (Family: none) | 4 |

Form PCT/ISA/210 (continuation of second sheet) (April 2005)

**EP 1 908 587 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 63062104 A
- JP 8016175 B
- JP 2001226501 A
- JP 2002090515 A